# EUROPÄISCHE PATENTSCHRIFT

(11) **EP 2 279 454 B1**
(45) Veröffentlichungstag und Bekanntmachung des Hinweises auf die Patenterteilung: **08.02.2012**
(21) Anmeldenummer: 09749746.5
(22) Anmeldetag: 13.05.2009
(51) Int. Cl.: G03F 7/033, B41C 1/05

(54) **FOTOPOLYMERISIERBARE FLEXODRUCKELEMENTE FÜR DEN DRUCK MIT UV-FARBEN**
PHOTOPOLYMERIZABLE FLEXOGRAPHIC PRINTING ELEMENTS FOR PRINTING WITH UV INKS
ELÉMENTS D'IMPRESSION FLEXOGRAPHIQUE PHOTOPOLYMÉRISABLES POUR L'IMPRESSION AVEC DES ENCRES UV

(30) Priorität: 19.05.2008 DE 102008024214
(43) Veröffentlichungstag der Anmeldung: 02.02.2011
(73) Patentinhaber: Flint Group Germany GmbH, 70469 Stuttgart (DE)
(72) Erfinder: STEBANI, Uwe, 67592 Flörsheim-Dalsheim (DE); DÖTTINGER, Stefanie, 70469 Stuttgart (DE)
(74) Vertreter: Schuck, Alexander
(86) Internationale Anmeldenummer: PCT/EP2009/055775
(87) Internationale Veröffentlichungsnummer: WO 2009/141256

(56) Entgegenhaltungen:
- WO-A-2005/050327
- US-A1- 2006 178 446

## Beschreibung

Die vorliegende Erfindung betrifft fotopolymerisierbare Flexodruckelemente, welche Cyclohexanpolycarbonsäureester als Weichmacher enthalten, sowie deren Verwendung zur Herstellung von Flexodruckformen für den Druck mit UV-Farben, insbesondere zum Schmalbahnetikettendruck mit UV-Farben

Flexodruck mittels UV-Farben ist prinzipiell bekannt. Die Technik wird insbesondere zum Herstellen von Etiketten eingesetzt. Beim Schmalbahnetikettendruck (UV Narrow Web Printing) wird eine Bahn, beispielsweise aus Papier oder selbstklebenden Kunststofffolien mit dem Etikettenmuster bedruckt. Die hierfür eingesetzten Druckmaschinen weisen Druckzylinder mit einem relativ kleinen Durchmesser auf, beispielsweise einem Durchmesser von nur 6 bis 12 cm. Beim Montieren auf den Druckzylinder müssen die eingesetzten Flexodruckplatten dementsprechend sehr flexibel sein, damit sie gut um die kleinen Druckzylinder gebogen werden können.

UV-Flexodruckfarben enthalten zum Aushärten Monomere mit ethylenisch ungesättigten Gruppen, wie beispielsweise Hexandioldiacrylat, Dipropylenglykoldiacrylat, Tripropylenglykoldiacrylat oder auch ethoxylierte Monomere wie ethoxyliertes Tripropylenglykoldiacrylat oder ethoxyliertes Trimethylolpropantriacrylat. Derartige Monomere können im Laufe der Zeit Flexodruckplatten aufquellen. Das Aufquellen der Flexodruckplatte führt aber mit zunehmender Dauer des Druckvorganges zu unerwünschten Veränderungen des Druckbildes, weil feine Druckelemente durch die Quellung eine Volumenzunahme erfahren und gleichzeitig die Härte der Flexodruckplatte abnehmen kann. Die einzelnen Elemente der Platte verbreitern sich, der Tonwertzuwachs nimmt zu und feine Bildelemente können zulaufen.

Die Quellbarkeit der Flexodruckplatte wird naturgemäß vom Vernetzungsgrad beeinflusst. Je höher der Vernetzungsgrad, desto geringer die Quellbarkeit der Platte. Höhere Vernetzung erhöht bei sonst gleichen Verhältnissen auch die Härte der Flexodruckplatten, was zum Rasterdruck durchaus erwünscht sein kann. Gleichzeitig verringert sich aber auch die Flexibilität der Flexodruckplatte, d.h. sie lassen sich schwieriger biegen, so dass deren Montage auf Druckzylinder mit geringem Durchmesser schwierig wird.

Es ist vorgeschlagen worden, für den Druck mit UV-Farben spezielle Bindemittel in den Flexodruckplatten einzusetzen. EP 833 206 A und EP 833 207 A schlagen vor, spezielle Blockcopolymere mit Styrol-Blöcken sowie Isopren- oder Butadien-Isopren-Blöcken einzusetzen, wobei die Peak-Temperatur der primären Dispersion von tan δ maximal 30°C beträgt. EP 992 849 A1 schlägt die Verwendung von Blockcopolymeren mit mindestens einem Styrol-Block sowie mindestens einem Styrol-Butadien-Block vor.

Es ist bekannt, Flexodruckplatten Weichmacher zuzusetzen. Beispielhaft sei hierzu auf die EP 992 849 A1, Abschnitt [0021] verwiesen. Besonders verbreitet als Weichmacher in Flexodruckplatten sind Weißöle oder oligomere Weichmacher, wie insbesondere Polybutadienöle.

Durch den Einsatz von Weichmachern kann die Flexibilität von Flexodruckplatten grundsätzlich erhöht werden. Größere Mengen von Weichmacher setzen aber gleichzeitig auch den Vernetzungsgrad herab, so dass die Flexodruckplatte wieder weicher wird, und dem entsprechend auch wieder stärker im Kontakt mit UV-Farben aufquillt.

Aufgabe der Erfindung war es, die Flexibilität von Flexodruckplatten für den Druck mit UV-Farben, insbesondere den Schmalbahnetikettendruck mit UV-Farben zu verbessern.

Überraschenderweise wurde gefunden, dass diese Aufgabe durch die Verwendung von Cyclohexanpolycarbonsäureestern als Weichmacher in Flexodruckplatten gelöst werden kann.

Dementsprechend wurde ein fotopolymerisierbares Flexodruckelement zur Herstellung von Flexodruckformen für den Druck mit UV-Farben gefunden, welches mindestens
- einen dimensionsstabilen Träger sowie
- eine fotopolymerisierbare, reliefbildende Schicht umfassend mindestens
   ■ 40 bis 90 Gew.-% eines thermoplastisch-elastomeren Blockcopolymers, umfassend mindestens einen Block, welcher im Wesentlichen aus Alkenylaromaten besteht und mindestens einen Block, welcher im Wesentlichen aus 1,3-Dienen besteht,
   ■ 1 bis 20 Gew.-% ethylenisch ungesättigte Monomere,
   ■ 0,1 bis 5 Gew.-% Fotoinitiator und
   ■ 1 bis 40 Gew.-% Weichmacher,
umfasst, wobei die Mengen jeweils auf die Gesamtmenge aller Komponenten der fotopolymerisierbaren Schicht bezogen sind,
und wobei es sich bei mindestens einem der Weichmacher um 1 bis 40 Gew.-% mindestens eines Cyclohexanpolycarbonsäureesters der allgemeinen Formel R¹-(COOR²)ₙ handelt, wobei n für 2, 3 oder 4 steht, R¹ für einen n-wertigen Cyclohexanrest und die Reste R² jeweils unabhängig voneinander für einen linearen, verzweigten oder cyclischen, aliphatischen Kohlenwasserstoffrest mit 3 bis 20 Kohlenstoffatomen.

In einer bevorzugten Ausführungsform der Erfindung handelt es sich bei dem thermoplastisch-elastomeren Blockcopolymer um ein Styrol-Isopren-Blockcoppolymer.

Weiterhin wurde ein Verfahren zur Herstellung von Flexodruckformen unter Verwendung derartiger Flexodruckelemente gefunden, sowie die Verwendung der erhaltenen Flexodruckformen zum Flexodruck mit UV-Farben.

Zu der Erfindung ist im Einzelnen das Folgende auszuführen:

Im Folgenden wird der Begriff "Flexodruckform" bzw. "Flexodruckplatte" für eine bereits vernetzte, druckfertige Druckform verwendet. Der Begriff "Flexodruckelement" wird in üblicher Art und Weise für das fotopolymerisierbare Ausgangsmaterial verwendet, welches zur Herstellung von Flexodruckformen bzw. Flexodruckplatten eingesetzt wird.

Bei den erfindungsgemäßen fotopolymerisierbaren Flexodruckelementen kann es sich sowohl um plattenförmige Flexodruckelemente als auch um zylindrische, bevorzugt endlosnahtlose Flexodruckelemente handeln.

Die erfindungsgemäßen fotopolymerisierbaren Flexodruckelemente umfassen mindestens einen dimensionsstabilen Träger sowie mindestens eine fotopolymerisierbare, reliefbildende Schicht.

Als dimensionsstabile Träger kommen die aus der Flexodruckplattentechnik bekannten Träger in Frage, beispielsweise Folien, Platten oder zylindrische Röhren. Bei den Materialien der Träger kann es sich beispielsweise um Metalle, wie beispielsweise Stahl oder Aluminium oder um Kunststoffe wie beispielsweise Polyethylenterephthalat, Polybutylenterephthalat, Polyethylennaphthalat oder Polycarbonat handeln. Die Träger können optional mit üblichen, haftvermittelnden Schichten behandelt sein. Geeignet sind insbesondere PET-Folien mit einer Dicke von 100 bis 200 µm.

Das in der fotopolymerisierbaren, reliefbildenden Schicht enthaltene fotopolymerisierbare Material umfasst mindestens ein thermoplastisch-elastomeres Blockcopolymer, mindestens ein ethylenisch ungesättigtes Monomer, mindestens einen Fotoinitiator, mindestens einen Weichmacher sowie optional weitere Komponenten.

Die thermoplastisch-elastomeren Blockcopolymere umfassen mindestens einen Block, welcher im Wesentlichen aus Alkenylaromaten besteht und mindestens einen Block, welcher im Wesentlichen aus 1,3-Dienen besteht. Bei den Alkenylaromaten kann es sich beispielsweise um Styrol, α-Methylstyrol oder Vinyltoluol handeln. Bevorzugt handelt es sich um Styrol. Bei den 1,3-Dienen handelt es sich bevorzugt um Butadien und/oder Isopren. Bei diesen Blockcopolymeren kann es sich sowohl um lineare, verzweigte oder radiale Blockcopolymere handeln. Im Allgemeinen handelt es sich um Dreiblockcopolymere vom A-B-A-Typ, es kann sich aber auch um Zweiblockpolymere vom A-B-Typ handeln, oder um solche mit mehreren alternierenden elastomeren und thermoplastischen Blöcken, z.B. A-B-A-B-A. Es können auch Gemische zweier oder mehrerer unterschiedlicher Blockcopolymere eingesetzt werden. Handelsübliche Dreiblockcopolymere enthalten häufig gewisse Anteile an Zweiblockcopolymeren. Die Dien-Einheiten können 1,2- oder 1,4-verknüpft sein. Weiterhin einsetzbar sind auch thermoplastisch elastomere Blockcopolymere mit Endblöcken aus Styrol und einem statistischen Styrol-Butadien-Mittelblock. Selbstverständlich können auch Gemische mehrerer thermoplastisch-elastomerer Bindemittel eingesetzt werden, vorausgesetzt, die Eigenschaften der reliefbildenden Schicht werden dadurch nicht negativ beeinflusst.

In einer bevorzugten Ausführungsform der Erfindung handelt es sich bei den thermoplastisch elastomeren Bindemitteln um mindestens ein Styrol-Isopren-Blockcopolymeres, insbesondere Styrol-Isopren-Styrol-Blockcopolymere, wobei die Polymere auch noch Anteile von Zweiblockcopolymeren Styrol-Isopren enthalten können. Bevorzugte Bindemittel vom Styrol-Isopren-Typ enthalten in der Regel 10 bis 30 Gew.-%, bevorzugt 12 bis 28 Gew.-% und besonders bevorzugt von 14 bis 25 Gew.-% Styrol. Diese Blockcopolymere haben üblicherweise ein mittleres Molekulargewicht M_{w} (Gewichtsmittel) von 100 000 bis 300 000 g/mol. Selbstverständlich können auch Gemische verschiedener Styrol-Isopren-Blockcopolymere verwendet werden. In einer zweiten Ausführungsform der Erfindung können bevorzugt radiale Isopren-Styrol-Blockcopolymere eingesetzt werden.

Die Isopren-Einheiten in den Polyisopren-Blöcken können 1,4-verknüpft sein, d.h. die verbleibende Doppelbindung ist in der Kette angeordnet oder 3,4-verknüft, d.h. die verbleibende Doppelbindung ist seitenständig angeordnet. Es können Blockcopolymere eingesetzt werden, welche im Wesentlich 1,4-Verknüpfungen aufweisen und Bindemittel, welche gewisse Anteile an 3,4-Verknüpfungen aufweisen. Die seitenständigen Vinylgruppen in Bindemitteln mit 3,4-verknüpften Isopreneinheiten können im Zuge der Vernetzung der fotopolymersierbaren Schicht ebenfalls reagieren können und dementsprechend eine Platte mit hoher Vernetzung ergeben. Beispielsweise können Styrol-Isopren-Blockcopolymere eingesetzt werden, welche einen Vinylgruppengehalt von 20 bis 70 % aufweisen.

In einer bevorzugten Ausführungsform der Erfindung kann man ein radiales Styrol-Isopren-Copolymer einsetzen, welches einen Vinylgruppenanteil von weniger als 10 % aufweist. In einer zweiten bevorzugten Ausführungsform der Erfindung setzt man ein Gemisch von zwei verschiedenen Styrol-Isopren-Blockcopolymeren ein. Bevorzugt weist hierbei eines davon einen Vinylgruppengehalt von mindestens 20 % auf, insbesondere 20 bis 70 %, bevorzugt 25 bis 45 %. Das andere kann einen niedrigen Vinylgruppengehalt, beispielsweise einen von weniger als 10 % aufweisen. Weiterhin bevorzugt kann man ein Gemisch zweier Styrol-Isopren-Copolymerer einsetzen, von denen eines einen hohen Diblockanteil von mehr als 40 Gew.-% aufweist und das zweite einen niedrigeren Diblockanteil von 10 - 30 Gew. %.

Neben den genannten thermoplastisch-elastomeren Blockcopolymeren, insbesondere den Styrol-Isopren-Blockcopolymeren kann die fotopolymerisierbare Schicht auch noch weitere, von den Blockcopolymeren verschiedene elastomere Bindemittel umfassen. Mit derartigen zusätzlichen Bindemitteln, auch sekundäre Bindemittel genannt, lassen sich die Eigenschaften der fotopolymerisierbaren Schicht modifizieren. Ein Beispiel für ein sekundäres Bindemittel sind Vinyltoluol-α-Methylstyrol-Copolymere. Im Regelfalle sollte die Menge derartiger sekundärer Bindemittel 25 Gew.-% bezüglich der Gesamtmenge aller eingesetzten Bindemittel nicht überschreiten. Bevorzugt übersteigt die Menge derartiger sekundärer Bindemittel nicht 15 Gew. %, besonders bevorzugt nicht 10 Gew.-%.

Die Gesamtmenge an Bindemitteln beträgt üblicherweise 40 bis 90 Gew.-% bezüglich der Summe aller Bestandteile der reliefbildenden Schicht, bevorzugt 50 bis 90 Gew.-% und besonders bevorzugt 60 bis 85 Gew.-%.

Die fotopolymerisierbare reliefbildende Schicht umfasst weiterhin mindestens ein ethylenisch ungesättigtes Monomer. Die eingesetzten Monomere sollten mit den Bindemitteln verträglich sein und weisen mindestens eine polymerisierbare, ethylenisch ungesättigte Gruppe auf. Als Monomere können insbesondere Ester oder Amide der Acrylsäure oder Methacrylsäure mit mono- oder polyfunktionellen Alkoholen, Aminen, Aminoalkoholen oder Hydroxyethern und -estern, Ester der Fumar- oder Maleinsäure und Allylverbindungen eingesetzt werden. Bevorzugt sind Ester der Acrylsäure oder Methacrylsäure. Bevorzugt sind 1,4-Butandioldiacrylat, 1,6-Hexandioldiacrylat, 1,6-Hexandioldimethacrylat, 1,9-Nonandioldiacrylat oder Trimethylolpropantri(meth)acrylat. Selbstverständlich können Gemische verschiedener Monomere eingesetzt werden.

Bevorzugt umfasst die reliefbildende Schicht mindestens ein ethylenisch ungesättigtes Monomer mit zwei ethylenisch ungesättigten Gruppen, insbesondere 1,6-Hexandioldiacrylat und/oder 1,6-Hexandioldimethacrylat.

Die Gesamtmenge aller Monomere in der reliefbildenden Schicht zusammen beträgt 1 bis 20 Gew.-%, bevorzugt 5 bis 20 Gew.-%, besonders bevorzugt 8 bis 20 Gew.-%, ganz besonders bevorzugt 8 bis 18 Gew.-% und beispielsweise 12 bis 18 Gew.-%, jeweils bezogen auf die Summe aller Bestandteile der reliefbildenden Schicht. Die Menge von Monomeren mit zwei ethylenisch ungesättigten Gruppen beträgt bevorzugt 5 bis 20 Gew.-%, bezogen auf die Summe aller Bestandteile der reliefbildenden Schicht, bevorzugt 8 bis 18 Gew.-%.

Die reliefbildende, fotopolymerisierbare Schicht umfasst weiterhin mindestens einen Fotoinitiator oder ein Fotoinitiatorsystem. Beispiele für geeignete Initiatoren sind Benzoin oder Benzoinderivate, wie Methylbenzoin oder Benzoinether, Benzilderivate, wie Benzilketale, Acylarylphosphinoxide, Acylarylphosphinsäureester, Mehrkernchinone oder Benzophenone. Die Menge an Fotoinitiator in der reliefbildenden Schicht beträgt in der Regel 0,1 bis 5 Gew.-%, bevorzugt 1 bis 4 Gew.-% und besonders bevorzugt 1,5 bis 3 Gew.-%, bezogen auf die Menge aller Bestandteile der reliefbildenden Schicht.

Erfindungsgemäß umfasst die Flexodruckplatte weiterhin mindestens einen Cyclohexanpolycarbonsäureester der allgemeinen Formel R¹-(COOR²)ₙ. Hierbei steht n für 2, 3 oder 4, bevorzugt 2 oder 3 und besonders bevorzugt für 2. Bei R¹ handelt es sich um einen n-wertigen Cyclohexylrest. Bei den Resten R² handelt es sich jeweils unabhängig voneinander für einen linearen, verzweigten oder cyclischen, aliphatischen Kohlenwasserstoffrest mit 3 bis 20 Kohlenstoffatomen, bevorzugt 4 bis 18 und besonders bevorzugt 6 bis 12 Kohlenstoffatomen. Selbstverständlich können auch Gemische verschiedener Cyclohexanpolycarbonsäureester als Weichmacher eingesetzt werden. Cyclohexanpolycarbonsäureester, deren Herstellung und Verwendung als Weichmacher sind prinzipiell bekannt. Beispiele derartiger Cyclohexanpolycarbonsäureester sind in WO 04/081127 genannt.

Bevorzugt handelt es sich um Cyclohexandicarbonsäureester der Formel R¹-(COOR²)₂, wobei R¹ hier für einen zweiwertigen Cyclohexanrest steht und R² die obige Bedeutung hat, wobei es sich um Cyclohexan-1,2-dicarbonsäureester, Cyclohexan-1,3-dicarbonsäureester und Cyclohexan-1,4-dicarbonsäureester handeln kann. Besonders bevorzugt handelt es sich um Cyclohexan-1,2-dicarbonsäureester.

Beispiele insbesondere geeigneter Cyclohexanpolycarbonsäureester umfassen Cyclohexan-1,2-dicarbonsäuredüsopropylester, Cyclohexan-1,2-dicarbonsäuredi-n-hexylester, Cyclohexan-1,2-dicarbonsäuredüsohexylester, Cyclohexan-1,2-dicarbonsäuredi-n-heptylester, Cyc-Iohexan-1,2-dicarbonsäuredüsoheptylester, Cyclohexan-1,2-dicarbonsäuredi-2-ethylhexylester, Cyclohexan-1,2-dicarbonsäuredi-n-nonylester, Cyclohexan-1,2-dicarbonsäurediisononylester oder Cyclohexan-1,2-dicarbonsäuredi-n-dodecylester. Weitere Beispiele sind in WO 04/081127, Seite 7, Zeile 6 bis Seite 14, Zeile 14 genannt.

Ganz besonders bevorzugt zum Einsatz im erfindungsgemäßen Flexodruckelement ist Cyc-Iohexan-1,2-dicarbonsäurediisononylester.

Im Allgemeinen weisen die erfindungsgemäß eingesetzten Cyclohexan-1,2-dicarbonsäureester Alkylreste mit 3 bis 20, bevorzugt 4 bis 18, besonders bevorzugt 6 bis 12, insbesondere 9 C-Atome auf, wobei die Alkylreste verzweigt oder geradkettig sein können. Geeignete Cyclohexan-1.2-dicarbonsäureester mit Alkylresten mit 3 bis 20 C-Atomen sind in US 2006/0178446, Absätze [0032] bis [0042] aufgelistet. Die Cyclohexan-1,2-dicarbonsäureester können Mischester sein, also Alkylreste unterschiedlicher Kettenlänge enthalten. Im Allgemeinen sind die Alkylreste verzweigt, wobei zahlreich unterschiedliche isomere Formen von Alkylresten der gleichen Kettenlänge in den Cyclohexan-1,2-dicarbonsäureestern vorkommen können. Die erfindungsgemäß eingesetzten Cyclohexan-1,2-dicarbonsäureester Alkylreste sind also häufig Isomerengemische.

Geeignet sind beispielsweise die in WO 99/32427 offenbarten Cyclohexan-1,2-dicarbonsäureester:
Cyclohexan-1,2-dicarbonsäuredi(isopentyl)ester, erhältlich durch Hydrierung von Di(isopentyl)phthalat mit der Chemical Abstracts Registry Nummer (im Folgenden: CAS Nr.) 84777-06-0;
Cyclohexan-1,2-dicarbonsäuredi(isoheptyl)ester, erhältlich durch Hydrierung von Di(isoheptyl)phthalat mit der CAS Nr. 71888-89-6;
Cyclohexan-1,2-dicarbonsäuredi(isononyl)ester, erhältlich durch Hydrierung eines Di(isononyl)phthalats mit der CAS Nr. 68515-48-0;
Cyclohexan-1,2-dicarbonsäuredi(isononyl)ester, erhältlich durch Hydrierung eines Di(isononyl)phthalats mit der CAS Nr. 28553-12-0, basierend auf n-Buten;
Cyclohexan-1,2-dicarbonsäuredi(isononyl)ester, erhältlich durch Hydrierung eines Di(isononyl)phthalats mit der CAS Nr. 28553-12-0 basierend auf Isobuten;
ein 1,2-Di-C₉-Ester der Cyclohexandicarbonsäure, erhältlich durch Hydrierung eines Di(nonyl)phthalats mit der CAS Nr. 68515-46-8;
ein Cyclohexan-1,2-dicarbonsäuredi(isodecyl)ester erhältlich durch Hydrierung eines Di(isodecyl)phthalats mit der CAS Nr. 68515-49-1;
ein 1,2-Di-C₇₋₁₁-Ester der Cyclohexandicarbonsäure, erhältlich durch Hydrierung des entsprechenden Phthalsäureesters mit der CAS Nr. 68515-42-4;
ein 1,2-Di-C₇₋₁₁-Ester der Cyclohexandicarbonsäure, erhältlich durch Hydrierung der DI-C₇₋₁₁-Phthalate mit folgenden CAS Nr.:111 381-89-6, 111 381 90-9, 111 381 91-0, 68515-44-6, 68515-45-7 und 3648-20-7;
ein 1,2-Di-C₉₋₁₁-Ester der Cyclohexandicarbonsäure, erhältlich durch Hydrierung eines Di-C₉-₁₁-Phthalats mit der CAS Nr. 98515-43-5;
ein 1,2-Di(isodecyl)cyclohexandicarbonsäureester, erhältlich durch Hydrierung eines Di(isodecyl)phthalats, das hauptsächlich aus Di-(2-propylheptyl)phthalat besteht;
ein 1,2-Di-C₇₋₉-Cyclohexandicarbonsäureester, erhältlich durch Hydrierung des entsprechenden Phthalsäureesters, der verzweigtkettige oder lineare C₇₋₉-Alkylester-gruppen aufweist; beispielsweise als Ausgangsprodukte verwendbare Phthalate haben die folgende CAS Nr.:
Di-C₇₋₉-Alkylphthalat mit der CAS Nr. 111 381-89-6;
Di-C₇-Alkylphthalat mit der CAS Nr. 68515-44-6; und
Di-C₉-Alkylphthalat mit der CAS Nr. 68515-45-7.

Erfindungsgemäß sind auch Hydrierprodukte von Phthalsäure-Mischestern mit C₁₀-und C₁₃-Alkoholen verwendbar, wie sie in der DE-A 10032580.7 beschrieben sind.

Besonders bevorzugt sind die Dinonylester der Cyclohexan-1,2-dicarbonsäure, beispielsweise die oben genannten Diisononylester(gemische), oder der Cyclohexan-1,2-diisononylester, welcher unter dem Namen Hexamoll^{®} DINCH der Fa. BASF SE kommerziell erhältlich ist.

Neben den Cyclohexanpolycarbonsäureestern können die erfindungsgemäßen Flexodruckelemente darüber hinaus optional noch weitere Weichmacher enthalten. Beispiele für weitere Weichmacher umfassen paraffinische, naphthenische oder aromatische Mineralöle, synthetische Oligomere oder Harze wie Oligostyrol, hochsiedende Ester, oligomere Styrol-Butadien-Copolymere, oligomere α-Methylstyrol/p-Methylstyrol-Copolymere, flüssige Oligobutadiene, insbesondere solche mit einem mittleren Molekulargewicht zwischen 500 und 5000 g/mol, oder flüssige oligomere Acryinitril-Butadien-Copolymere oder oligomere Ethylen-Propylen-Dien-Copolymere.

Die Menge aller Weichmacher im erfindungsgemäßen Flexodruckelement beträgt 1 bis 40 Gew.-% und bevorzugt 1 bis 20 Gew.-%, mit der Maßgabe, dass die Menge aller Cyclohexanpolycarbonsäureester im erfindungsgemäßen Flexodruckelement 1 bis 40 Gew.-%, bevorzugt 1 bis 20 Gew.-%, besonders bevorzugt 1 bis 10 Gew.-% und beispielsweise 2 bis 8 Gew. % beträgt. Die absolute Menge der Weichmacher richtet sich auch nach dem jeweiligen Bindemittelsystem. Bei Platten auf Basis eines Styrol-Isopren-Bindemittelsystems haben sich Weichmachermengen von 1 bis 10 Gew.-% bewährt. In einer vorteilhaften Ausgestaltung der Erfindung werden hierbei als Weichmacher ausschließlich Cyclohexanpolycarbonsäureester eingesetzt. Im Falle des Styrol-Isopren-Bindemittelsystems werden generell weniger Weichmacher benötigt, da der Kautschuk mit im Allgemeinen lediglich ca. 15 -16% Styrol weicher ist als ein Styrol-Butadien-Kautschuk mit beispielsweise 28 bis 30% Styrol. Bei Platten auf Basis eines Styrol-Butadien-Bindemittelsystems haben sich Weichmachermengen von 20 bis 40 Gew.-% bewährt. In einer vorteilhaften Ausgestaltung dieser Ausführungsform kann es sich dabei um 1 bis 10 Gew.-% Cyclohexanpolycarbonsäureester und bei der verbleibenden Menge um Polybutadienöle handeln.

Die reliefbildende Schicht kann weiterhin typische Additive und Zusatzstoffe enthalten. Beipiele derartiger Zusatzstoffe und Additive umfassen Farbstoffe, Inhibitoren für die thermische Polymerisation, Füllstoffe oder Antioxidation. Der Fachmann trifft je nach den gewünschten Eigenschaften der Schicht eine entsprechende Auswahl. Die Menge derartiger Zusatzstoffe sollte aber im Regelfalle 10 Gew. % bezogen auf die Menge aller Komponenten der reliefbildenden Schicht, bevorzugt 5 Gew. % nicht überschreiten.

Bei dem fotopolymerisierbaren Flexodruckelement kann es sich selbstverständlich auch um ein mehrschichtiges Flexodruckelement handeln, welches zwei oder mehrere, im Regelfalle zwei fotopolymerisierbare, reliefbildende Schichten aufweist, wobei mindestens eine der Schichten mindestens einen Cyclohexanpolycarbonsäureester umfasst. Durch einen zweischichtigen Aufbau kann man die Unterschicht insbesondere im Hinblick auf die elastischen Eigenschaften optimieren und die Oberschicht im Hinblick auf die drucktechnischen Eigenschaften, wie beispielsweise die Farbannahme.

Das fotopolymerisierbare Flexodruckelement kann auf der reliefbildenden Schicht optional in prinzipiell bekannter Art und Weise weiterhin eine Entklebeschicht aufweisen. Eine derartige Schicht wird eingesetzt, um zu verhindern, dass ein aufgelegtes fotographisches Negativ beim Belichten nicht auf der fotopolymerisierbaren Schicht festklebt. Eine Entklebeschicht kann beispielsweise aus Polyamid bestehen.

Das fotopolymerisierbare Flexodruckelement kann auf der Entklebeschicht optional weiterhin eine abziehbare Deckfolie, beispielsweise eine PET-Folie aufweisen, welche es vor Beschädigungen schützt.

Die erfindungsgemäßen fotopolymerisierbaren Flexodruckelemente lassen sich nach dem Fachmann prinzipiell bekannten Methoden herstellen, beispielsweise durch Schmelzextrusion, Gießen oder Laminieren in einem einstufigen oder mehrstufigen Produktionsprozess. Bevorzugt ist die Herstellung mittels Schmelzextrusion, bei dem man zunächst die Bestandteile der reliefbildenden Schicht in einem Extruder unter Erwärmen miteinander mischt. Zur Herstellung von flächenförmigen Flexodruckelementen kann die fotopolymeriserbare Masse aus dem Extruder durch eine Breitschlitzdüse zwischen zwei Folien ausgetragen und der Schichtenverbund kalandriert werden, wobei sich die Art der Folien nach dem gewünschten Verwendungszweck richtet. Es kann sich hierbei um Folien handeln, welche eine gute Haftung mit der fotopolymerisierbaren Schicht aufweisen oder um leicht abziehbare (temporäre) Folien. Zur Herstellung von flächenförmigen Flexodruckelementen wird üblicherweise eine gut haftende Trägerfolie und eine abziehbare Deckfolie eingesetzt. Ist die Weiterverarbeitung der Schicht zu zylindrischen Flexodruckelementen nach dem in dieser Erfindung beschriebenen Verfahren vorgesehen, dann werden zwei abziehbare Folien verwendet. Zur Herstellung von fotopolymerisierbaren, zylindrischen Flexodruckelementen kann auch eine nahtlose Schicht mittels Ringextrusion direkt auf einen zylindrischen Träger aufgebracht werden. Die Dicke der fotopolymerisierbaren Schicht beträgt im Allgemeinen 0,4 bis 7 mm, bevorzugt 0,5 bis 4 mm und besonders bevorzugt 0,7 bis 2,5 mm. Fotopolymerisierbare Flexodruckelemente für den Schmalbahnetikettendruck mit UV-Farben weisen in der Regel relativ dünne fotopolymeriserbare Schichten auf, beispielsweise mit einer Schichtdicke von 0,7 bis 2,0 mm, bevorzugt 1,0 bis 1,8 mm.

Die Herstellung von zylindrischen endlos-nahtlosen Flexodruckelementen und deren Weiterverarbeitung zu endlos-nahtlosen Druckformen kann in Anlehnung an das von WO 2004/092841 beschriebene Verfahren erfolgen. Sie kann aber selbstverständlich auch mittels anderer Techniken vorgenommen werden.

Die Weiterverarbeitung der fotopolymerisierbaren Flexodruckelemente zu fertigen Flexodruckformen kann nach verschiedenen Techniken erfolgen. Die Flexodruckelemente können beispielsweise auf prinzipiell bekannte Art und Weise bildmäßig belichtet und die unbelichteten Bereiche der reliefbildenden Schicht anschließend mittels eines geeigneten Entwicklungsprozesses entfernt werden. Die bildmäßige Belichtung kann grundsätzlich durch Bedecken der fotopolymerisierbaren Flexodruckelemente mit einer fotografischen Maske und Belichten durch die Maske hindurch erfolgen. Sofern das Flexodruckelement durch eine Deckfolie geschützt ist, wird diese vorher abgezogen.

Bevorzugt wird die Bebilderung aber mittels digitaler Masken vorgenommen. Derartige Masken sind auch als In-situ-Masken bekannt. Hierzu wird zunächst eine digital bebilderbare Schicht auf die fotopolymerisierbare, reliefbildende Schicht aufgebracht. Bevorzugt handelt es sich bei der digital bebilderbaren Schicht um eine IR-ablative Schicht, Ink-Jet-Schicht oder thermografisch beschreibbare Schicht.

IR-ablative Schichten bzw. Masken sind für die Wellenlänge des aktinischen Lichtes opak und umfassen üblicherweise ein Bindemittel sowie mindestens einen IR-Absorber wie beispielsweise Ruß. Ruß sorgt auch dafür, dass die Schicht opak ist. In die IR-ablative Schicht kann mittels eines IR-Lasers eine Maske eingeschrieben werden, d.h. die Schicht wird an den Stellen, an denen sie vom Laserstrahl getroffen wird, zersetzt und abgetragen. Beispiele für die Bebilderung von Flexodruckelementen mit IR-ablativen Masken sind beispielsweise in EP-A 654 150 oder EP-A 1 069 475 offenbart.

Bei Ink-Jet-Schichten wird eine mit Ink-Jet-Tinten beschreibbare, für aktinisches Licht durchlässige Schicht, beispielsweise eine Gelatine-Schicht aufgetragen. Auf diese wird mittels Ink-Jet-Druckern eine Maske mit opaker Tinte aufgetragen. Beispiele sind in EP-A 1 072 953 offenbart.

Bei thermografischen Schichten handelt es sich um Schichten, die Substanzen enthalten, die sich unter dem Einfluss von Hitze schwarz färben. Derartige Schichten umfassen beispielsweise ein Bindemittel und ein organisches Silbersalz und können mittels eines Druckers mit Thermokopf bebildert werden. Beispiele sind in EP-A 1 070 989 offenbart.

Die digital bebilderbaren Schichten können durch Lösen bzw. Dispergieren aller Bestandteile der jeweiligen Schicht in einem geeigneten Lösemittel und Aufbringen der Lösung auf die fotopolymerisierbare Schicht des zylindrischen Flexodruckelementes, gefolgt vom Verdampfen des Lösemittels hergestellt werden. Das Aufbringen der digital bebilderbaren Schicht kann beispielsweise durch Aufsprühen oder mittels der von EP-A 1 158 365 beschriebenen Technik erfolgen.

Die digital bebilderbaren Schichten können aber auch in einem separaten Beschichtungsschritt zunächst auf eine PET-Folie beschichtet werden, welche dann im Zuge der Herstellung des Flexodruckelements mittels Schmelzextrusion zur Herstellung eines flächigen Schichtverbundes verwendet wird, indem sie als Deckfolie beim Kalandrierprozeß eingesetzt wird.

Nach dem Aufbringen der digital bebilderbaren Schicht wird diese mittels der jeweils geeigneten Technik bebildert und anschließend die fotopolymerisierbare Schicht durch die gebildete Maske hindurch in prinzipiell bekannter Art und Weise mittels aktinischen Lichts bestrahlt. Als aktinisches, also chemisch "wirksames" Licht eignet sich insbesondere UVA- bzw. UV/VIS-Strahlung. Belichter für plattenförmige Flexodruckelemente sowie Rundbelichter zur gleichmäßigen Belichtung von zylindrischen Flexodruckelementen sind kommerziell erhältlich.

Das Entwickeln der bildmäßig belichteten Schicht kann auf konventionelle Art und Weise mittels eines Lösemittels oder eines Lösemittelgemisches erfolgen. Dabei werden die nicht belichteten, d.h. die von der Maske abgedeckten Bereiche der Reliefschicht durch Auflösen im Entwickler entfernt, während die belichteten, also vernetzten Bereiche erhalten bleiben. Die Maske oder die Reste der Maske werden ebenfalls vom Entwickler entfernt, falls die Komponenten darin löslich sind. Falls die Maske nicht im Entwickler löslich ist, wird sie gegebenenfalls vor dem Entwickeln mit Hilfe eines zweiten Lösemittels entfernt.

Die Entwicklung kann auch thermisch erfolgen. Bei der thermischen Entwicklung wird kein Lösemittel eingesetzt. Stattdessen wird die reliefbildende Schicht nach der bildmäßigen Belichtung mit einem absorbierenden Material in Kontakt gebracht und erwärmt. Bei dem absorbierenden Material handelt es sich beispielsweise um ein poröses Vlies, beispielsweise aus Nylon, Polyester, Cellulose oder anorganischen Materialien. Es wird auf eine solche Temperatur erwärmt, dass sich die nicht polymerisierten Anteile der reliefbildenden Schicht verflüssigen und vom Vlies aufgesogen werden können. Das voll gesogene Vlies wird anschließend entfernt. Einzelheiten zur thermischen Entwicklung sind beispielsweise von US 3,264,103, US 5,175,072, WO 96/14603 oder WO 01/88615 offenbart. Die Maske kann gegebenenfalls vorher mittels eines geeigneten Lösemittels oder ebenfalls thermisch entfernt werden.

Die Herstellung von Flexodruckformen aus den fotopolymerisierbaren Flexodruckelementen kann auch mittels Laser-Direktgravur vorgenommen werden. Bei diesem Verfahren wird die fotopolymerisierbare Schicht zunächst ohne Auflegen einer Maske vollständig im gesamten Volumen mit aktinischem Licht, Elektronenstrahlen oder γ-Strahlen vernetzt. Anschließend wird in die vernetzte Schicht mit einem oder mehreren Lasern ein Druckrelief eingraviert.

Die vollflächige Vernetzung kann mit üblichen Belichtern für Flexodruckformen wie oben beschrieben erfolgen. Besonders vorteilhaft kann sie aber-insbesondere bei zylindrischen, endlos-nahtlosen Flexodruckformen- auch in Anlehnung an das in WO 01/39897 beschriebene Verfahren erfolgen. Hierbei wird in Anwesenheit eines Schutzgases, welches schwerer ist als Luft, beispielsweise CO₂ oder Ar, belichtet. Das fotopolymerisierbare, zylindrische Flexodruckelement wird hierzu in ein mit Schutzgas gefülltes Tauchbecken abgesenkt, dessen Wände bevorzugt mit einem reflektierenden Material, beispielsweise Aluminium-Folie, ausgekleidet sind. Anschließend wird mit aktinischem Licht belichtet. Es können hierzu im Prinzip die üblichen UV- bzw. UV/VIS-Quellen für aktinisches Licht verwendet werden. Bevorzugt sind Lichtquellen, die Licht mit einer Wellenlänge von 200 bis 400 nm emittieren. Beispielsweise können übliche UV-A-Röhren, UV-C-Röhren, UV-Strahler oder Kombinationen davon verwendet werden.

Bei der Laser-Direktgravur absorbiert die Reliefschicht Laserstrahlung in einem solchen Ausmaß, dass sie an den Stellen, an denen sie einem Laserstrahl ausreichender Intensität ausgesetzt ist, entfernt oder zumindest abgelöst wird. Vorzugsweise wird die Schicht dabei ohne vorher zu schmelzen verdampft oder thermisch oder oxidativ zersetzt, so dass ihre Zersetzungsprodukte in Form von heißen Gasen, Dämpfen, Rauch oder kleinen Partikeln von der Schicht entfernt werden.

Zur Gravur der erfindungsgemäß eingesetzten reliefbildenden Schichten eignen sich insbesondere Laser, die eine Wellenlänge von 9000 nm bis 12 000 nm aufweisen. Zu nennen sind hier insbesondere CO₂-Laser. Die in der reliefbildenden Schicht verwendeten Bindemittel absorbieren die Strahlung derartiger Laser in ausreichendem Maße, um graviert werden zu können.

Vorteilhaft kann die erhaltene Flexodruckform im Anschluss an die Lasergravur in einem weiteren Verfahrensschritt nachgereinigt werden. In manchen Fällen kann dies durch einfaches Abblasen mit Druckluft oder Abbürsten geschehen. Es ist aber bevorzugt, zum Nachreinigen ein flüssiges Reinigungsmittel einzusetzen, um auch Polymerbruchstücke vollständig entfernen zu können. Geeignet sind beispielsweise wässrige Reinigungsmittel, welche im Wesentlichen aus Wasser sowie optional geringen Mengen von Alkoholen bestehen, und die zur Unterstützung des Reinigungsvorganges Hilfsmittel, wie beispielsweise Tenside, Emulgatoren, Dispergierhilfsmittel oder Basen enthalten können. Geeignet sind auch "Wasser-in-Öl"-Emulsionen, wie von EP-A 463 016 offenbart. Bevorzugt werden Reinigungsmittel eingesetzt, welche mindestens eine organische Komponente aufweisen, die in der Lage ist, die im Zuge der Lasergravur auf dem Relief des Flexodruckelementes abgelagerten Zersetzungsprodukte abzulösen, ohne dass die Reliefschicht während des Reinigungsvorganges wesentlich gequollen wird. Derartige Reinigungsmittel sind beispielsweise in WO 2005/113240 offenbart.

Die nach dem erfindungsgemäßen Verfahren hergestellten Flexodruckformen weisen eine sehr gute Flexibilität auf. Die Wirkung der erfindungsgemäß verwendeten Cyclohexanpolycarbonsäureester ist hierbei insbesondere bei stärker vernetzten, härteren Flexodruckformen besonders ausgeprägt.

Die Reliefschicht der druckfertigen Flexodruckformen weist bei einer Schichtstärke von 1,14 mm im Allgemeinen eine Shore A-Härte nach DIN 53505 von 30 bis 90 Shore A, bevorzugt von 50 bis 85 Shore A und besonders bevorzugt 60 bis 85 Shore A und ganz besonders bevorzugt von 75 bis 85 Shore A auf. Die Messungen werden mit einem Härtemeßgerät entsprechend der Beschreibung von DIN 53505 durchgeführt.

Die druckfertigen Flexodruckformen können bevorzugt zum Flexodruck unter Verwendung von UV-Farben eingesetzt werden. Selbstverständlich können sie aber auch zum Druck mit anderen Farben, z.B. üblichen Flexodruckfarben auf Wasser-oder Alkoholbasis eingesetzt werden.

Zum Druck mit den erfindungsgemäßen Flexodruckformen, insbesondere mit den Flexodruckformen auf Basis von Styrol-Isopren-Bindemitteln, können bevorzugt Druckfarben mit vergleichsweise polaren Monomeren eingesetzt werden. Geeignet sind insbesondere UV-Druckfarben, welche Acrylester auf Basis von Polyetherpolyolen enthalten, wie beispielsweise ethoxyliertes Tripropylenglykoldiacrylat, ethoxyliertes Trimethylolpropantriacrylat, Dipropylenglykoldiacrylat oder Triproylenglykoltriacrylat.

Zum Flexodruck mit UV-Farben können übliche Flexodruckmaschinen eingesetzt werden, die für den Druck mit UV-Farben ausgestattet sind. Es wird mindestens eine Flexodruckform auf einen Druckzylinder montiert; für den Mehrfarbdruck werden je nach Drucktechnik drei, vier oder noch mehr Platten eingesetzt. Hiernach wird in üblicher Art und Weise mittels eines Farbwerkes UV-härtbare Druckfarbe auf die Flexodruckform übertragen, die UV-härtbare Druckfarbe durch Rotieren des Druckzylinders von der Flexodruckform auf den Bedruckstoff übertragen und danach die UV-härtbare Druckfarbe auf dem Substrat mittels UV-Strahlung aushärtet. Beim Mehrfarbdruck wird eine der Zahl der Farbwerke entsprechende Zahl von Platten verwendet.

Bevorzugt können die Flexodruckformen für den Schmalbahnetikettendruck (Narrow Web) verwendet werden. Hierzu werden bevorzugt Druckmaschinen eingesetzt, deren Druckzylinder in der Regel eine Länge von 60 cm nicht überschreitet und einen Durchmesser von 5 bis 15 cm aufweist. Er kann beispielsweise eine Länge von 30 bis 60 cm in besonderen Fällen auch nur ca. 10 cm aufweisen. Mit dieser Technik können Etiketten, insbesondere selbstklebende Etiketten wie beispielsweise Aufkleber oder Haftetiketten aus Papier und Folien gedruckt werden. Weiterhin können beispielsweise Wickeletiketten (Wrap arounds), Sleeve-Folien, Inmould-Etiketten (beispielsweise für Eisverpackungen), Laminate (beispielsweise für Zahnpastatuben), Produkte für technische Spezialanwendungen (beispielsweise Vignetten) oder auch ganz allgemein Verpackungen aus Folien, Papier oder Karton gedruckt werden.

Die nachfolgenden Beispiele sollen die Erfindung näher erläutern.

### Beispiele

### 1. Allgemeine Vorschrift zur Herstellung der fotopolymerisierbaren Flexodruckelemente:

Die Komponenten zur Herstellung der fotopolymerisierbaren Schicht wurden in einem Doppelschneckenextruder auf übliche Art und Weise intensiv bei einer Temperatur von ca. 125°C miteinander gemischt, in üblicher Art und Weise durch eine Breitschlitzdüse ausgetragen und zwischen einen dimensionsstabilen Träger und eine Deckfolie kalandriert.

Als Träger wurde eine übliche, mit einem Haftlack beschichtete PET-Folie mit einer Dicke von 175 µm eingesetzt, und als Deckfolie wurde eine mit einer üblichen Entklebeschicht versehene PET-Folie mit einer Dicke von 125 µm eingesetzt. Der Verbund aus Trägerschicht und photopolymerer, reliefbildender Schicht hatte jeweils eine Gesamtdicke von 1,14 mm.

### 2. Allgemeine Vorschrift zur Herstellung der Flexodruckplatten

Die gemäß 1) erhaltenen fotopolymerisierbaren Flexodruckelemente wurden jeweils 50 s (bzw. 20 s) von der Rückseite vorbelichtet, anschließend 24 min von der Vorderseite mit UV-A-Strahlung unter Vakuum durch eine aufgelegte Maske hindurch bestrahlt, mit einer Auswaschgeschwindigkeit von 140 mm/min bei 30°C in einem handelsüblichen Auswaschmittel für Flexodruckplatten (Nylosolv^{®} A) ausgewaschen (Bürstenbeistellung 0 mm), 2 h bei 65 °C getrocknet und zur Entklebung 10 min mit UV-A-Strahlung sowie 20 min UV-C-Strahlung nachbelichtet. Zur Belichtung wurde ein handelsüblicher Belichter für Flexodruckplatten - nyloflex^{®}-Belichter F III - verwendet.

Zur Herstellung der langen Streifen für die Flexibilitätsmessungen, wurde in der geschilderten Art ohne das Auflegen eines Negativs belichtet, so dass ein vollflächig vernetzter Streifen erhalten wurde.

### 3. Bestimmung der Messwerte

Von den erhaltenen Flexodruckplatten wurden jeweils die Shore A-Härte sowie die Flexibilität bestimmt. Die Messungen wurden einmal nach Herstellung der Flexodruckplatten vorgenommen und ein zweites Mal nach einer Wartezeit von 9 bis 13 Tagen.

### 3.1 Bestimmung der Shore Härte

Die Messung der Shore A Härte erfolgte nach DIN 53 505 an den 1,14 mm dicken Flexodruckplatten mit einem typischen Härtemessgerät, mit welchem die Messungen nach DIN 53 505 durchgeführt werden.

### 3.2 Bestimmung der Flexibilität

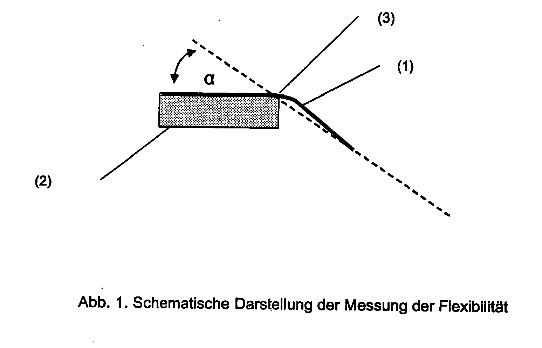

Das Prinzip der Messung ist schematisch in Abbildung 1 dargestellt.

Zur Bestimmung der Flexibilität werden aus Vollflächen der Flexodruckplatte jeweils 30 cm lange und 2 cm breite Streifen geschnitten. Zur Messung wird die Flexodruckplatte einschließlich Trägerfolie eingesetzt. Der Streifen der Flexodruckplatte (1) wird in einer Länge von 15 cm mit einem doppelseitigen Klebeband auf eine feste Auflage (2) geklebt. Der nicht unterstützte Teil des Streifens von ebenfalls 15 cm wird frei hängen lassen und biegt sich unter dem Einfluss der Schwerkraft mehr oder weniger durch. Gemessen wird der Winkel α zwischen dem Auflagepunkt der Platte (3) und dem frei hängenden Ende der Platte und der horizontalen, festen Druckplattenoberfläche auf der festen Auflage. Hierzu kann ein beliebiger Winkelmesser eingesetzt werden, beispielsweise der in US 4,766,675 beschriebene. Je größer der Winkel α, desto größer die Flexibilität der Flexodruckplatte und umso leichter lässt sie sich um einen Druckzylinder biegen.

### 3.3 Bestimmung der Quelldaten

Zur Bestimmung der prozentualen Gewichtszunahme durch Quellung wird jeweils eine Doppelbstimmung durchgeführt. Dabei werden zwei Flexodruckplattenstücke einer Größe von ca. 1 cm x 2 cm geschnitten, gewogen und anschließend mit dem Monomer oder der Druckfarbe, deren Quellverhalten untersucht werden sollen, bei Raumtemperatur vollständig benetzt. Anschließend wird 1 h bei 40°C oder 24 h bei Raumtemperatur gequollen. Die Proben werden anschließen mit einem Textiltuch ohne Lösemittel von Resten des anhaftenden Monomers bzw. der Druckfarbe gereingt und wieder gewogen. Aus der Differenz kann die Quellung als prozentuale Massenzunahme berechnet werden. Weiterhin wird die Shore A-Härte vor und nach dem Quellen bestimmt. Es wird jeweils der Mittelwert aus zwei Proben gebildet. Es wurden Quellversuche mit Hexandioldiacrylat, Dipropylenglykoldiacrylat sowie handelsüblichen UV-Druckfarben durchgeführt.

### 4. Verwendete Einsatzstoffe

- Quintac^{®} 3621 C: radiales Styrol-Isopren-Blockcopolymer, Styrol-Anteil 14 bis 15 Gew.-%, Diblockanteil ca. 26 %, Vinylgruppenanteil 7 bis 8 %.
- Hybrar^{®} 5125: SIS-Blockcopolymer mit einem Styrol-Anteil von 20 Gew.-%, Anteil an Vinylgruppen ca. 35 %.
- Kraton^{®} D 1113 BT: SIS-Blockcopolymer mit einem Styrol-Anteil von 15 bis 17 Gew.-%, Anteil an Vinylgruppen 5 bis 8 % %, Zweiblockanteil ca. 55 Gew.-%, M_{w} ca. 250 000 g/mol.
- Hexamoll^{®} DINCH: Cyclohexan-1,2-dicarbonsäurediisononylester
- Polyöl^{®} 130:: Polybutadienöl mit einem Molgewicht Mₙ von ca. 3000 g/mol, einer Viskosität von 2700 - 3300 mPas bei 20 °C und einem Anteil an 1,2-Vinylgruppen von ca. 1%.
- Lithene^{®} N 4 5000: Polybutadienöl (Synthomer) mit einem Molgewicht Mₙ von ca. 5000 g/mol, Viskosität ca. 4000 mPas bei 25°C, Anteil an 1,2-Vinylgruppen von ca. 10 bis 20%.
- Nisso^{®} PB B-1000: Polybutadienöl (Nippon Soda) mit einem Molgewicht Mₙ von 900-1300 g/mol, einem Anteil an 1,2-Vinylgruppen von > 85% und einer Viskosität von 5000 - 15000 mPas bei 45 °C.
- Winog^{®} 70: Weißöl
- Plastomol^{®} DNA: Diisononyladipat
- Monomere: 1,6-Hexandioldiacrylat oder 1,6-Hexandioldi(meth)acrylat
- Additive: Farbstoffe, Inhibitor für thermische Polymerisation

Gemäß der allgemeinen Vorschrift wurden die nachfolgend beschriebenen fotopolymerisierbaren Flexodruckelemente hergestellt und jeweils zu Flexodruckformen weiterverarbeitet. Die Zusammensetzung der Schicht sowie die erhaltenen Messwerte sind in den Tabellen 1 bis 4 zusammengestellt.

### Versuchsreihe 1 (Beispiel 1 und Vergleichsbeispiele V1, V2 und V3)

In Versuchsreihe 1 wurde eine Rezeptur mit einer sehr starken Vernetzung eingesetzt. Die Rezeptur enthält 15 Gew.-% Monomere, ein erstes SIS-Bindemittel sowie 35 Gew.-% eines SIS-Bindemittels mit einem hohen Anteil von Vinylgruppen, also Gruppen, welche ebenfalls vernetzen können. Die Shore A-Härte der Flexodruckplatten ist mit jeweils 86 bis 88 sehr hoch. Die Rezepturen und Ergebnisse sind in Tabelle 1 zusammengestellt.

Bei allen Versuchen beobachtet man, dass die Flexibilität nach einer Wartezeit von 1 bis 2 Wochen nach dem Herstellen der Platte noch etwas zunimmt. Die Platte V1, welche überhaupt keinen Weichmacher enthält, weist eine Flexibilität von nur 11° (nach 9 Tagen) auf. Verwendet man 7 % Polybutadienöle als Weichmacher (V2 und V3), so erhält man eine Flexibilität von 17° bis 19°, bei erfindungsgemäßer Verwendung von Cyclohexan-1,2 dicarbonsäurediisononylester (Beispiel 1) aber eine deutlich bessere Flexibilität von 27°.

Obwohl Beispiel 1 eine deutlich größere Flexibilität gegenüber den Vergleichsversuche V2 und V3 aufweist, liegen die Quellwerte auf gleichem Niveau. Die Quellwerte bei der Platte ohne Weichmacher sind etwas geringer. Die Quellversuche zeigen weiterhin, dass das stärker polare Monomer Dipropylenglykoldiacrylat die Flexodruckplatten wesentlich schwächer aufquillt als das weniger polare Monomer Hexandioldiacrylat.

### Versuchsreihe 2 (Beispiele 2 und 3, Vergleichsbeispiele V3 bis V6)

In Versuchsreihe 2 wurde eine Rezeptur mit einer etwas schwächeren, aber immer noch starken Vernetzung als bei Versuchsreihe 1 eingesetzt. Die Rezeptur enthält 12,5 Gew.-% Monomere, ein erstes SIS-Bindemittel sowie 36 Gew.-% eines SIS-Bindemittels mit einem hohen Anteil von Vinylgruppen, also Gruppen, welche ebenfalls vernetzen können. Es wurden 7,0 % bzw. 2,5 % Cyclohexan-1,2-dicarbonsäurediisononylester (Beispiele 1 und 2) sowie jeweils 7 % von anderen Weichmachern, nämlich von 2 verschiedenen Polybutadienölen, einem Weißöl sowie Diisononyladipat eingesetzt. Die Rezepturen und Ergebnisse sind in Tabelle 2 zusammengestellt.

Die Flexibilität bei Verwendung von 7 % Cyclohexan-1,2-dicarbonsäurediisononylester beträgt 25°, bei Verwendung von Weißöl oder Polybutadienölen werden 19° bis 21° erzielt. Mit 7 % Diisononyladipat wird zwar eine Flexibilität von 33° erzielt, aber die Shore A-Härte ist mit 83 auch die kleinste von allen Versuchen.

Die flexiblere Platte gemäß Beispiel 2 zeigt nach Quellung in den Acrylaten HDDA, DPGDA sowie in UV-Farbe, verglichen mit V3, V4 und V5, keine signifikant höhere Gewichtszunahme im Zuge der Quellung. Auch hier zeigen die Quellversuche, dass das stärker polare Monomer Dipropylenglykoldiacrylat die Flexodruckplatten wesentlich schwächer aufquillt als das weniger polare Monomer Hexandioldiacrylat.

### Versuchsreihe 3 (Beispiel 4, Vergleichsbeispiele V7 bis V9)

In Versuchsreihe 3 wurde eine vergleichsweise niedrig vernetzte Rezeptur eingesetzt. Die Monomerenmenge betrug 12,5 Gew.-%, aber es wurde nur vinylgruppenarme Bindemittel eingesetzt. Der Initiatorgehalt war mit 1,3 Gew.-% relativ niedrig. Die Shore A-Härten der Flexodruckplatten betrugen dementsprechend nur 73 bis 75. Die Rezepturen und Ergebnisse sind in Tabelle 3 zusammengestellt. Es wurden keine großen Unterschiede in der Flexibilität beobachtet.

### Versuchsreihe 4 (Beispiel 5, Vergleichsbeispiele V10 und V11)

In Versuchsreihe 4 wurde eine vergleichsweise niedrig vernetzte Rezeptur eingesetzt. Die Monomerenmenge betrug zwar 18,8 Gew.-%, aber es wurde nur vinylgruppenarme Bindemittel eingesetzt. Der Initiatorgehalt war mit 1,5 Gew.-% relativ niedrig. Die Shore A-Härten der Flexodruckplatten betrugen dementsprechend nur 76 bis 77. Die Rezepturen und Ergebnisse sind in Tabelle 4 zusammengestellt.

Es wurden keine großen Unterschiede in der Flexibilität beobachtet. Die prozentuale Gewichtszunahme im Zuge der Quelltests ist aufgrund der niedrigen Vernetzung generell höher als bei den anderen Versuchsreihen.

### Versuchsreihe 5 (Beispiel 6, Vergleichsbeispiele V12 und V13)

In Versuchsreihe 5 betrug die Monomerenmenge jeweils 12,5 Gew.-%. Durch Erhöhung des Initiatorgehaltes auf 2,3 Gew.-% wurde eine vergleichsweise hoch vernetzte Rezeptur erhalten. In Beispiel 6 wurde Cyclohexan-1,2-dicarbonsäurediisononylester als Weichmacher eingesetzt, in den beiden anderen Versuchen Polybutadienöle. Die Menge an Weichmacher wurde jeweils etwa so bemessen, dass die Flexodruckplatten eine vergleichbare Flexibilitäten von jeweils 32° bis 35° aufwiesen. Die Rezepturen und Ergebnisse sind in Tabelle 5 zusammengestellt.

Bei Verwendung von Cyclohexan-1,2-dicarbonsäurediisononylester waren hierzu nur 1,7 % erforderlich, während von den Polybutadienölen jeweils 6 % eingesetzt werden mussten. Hierdurch verringerte sich aber die Shore A-Härte deutlich auf 77 bzw. 78, während bei Verwendung von Cyc!ohexan-1,2-dicarbonsäurediisononylester die Shore A-Härte 81 betrug.

Die Beispiele und Vergleichsbeispiele zeigen, dass die erfindungsgemäß verwendeten Cyclohexanpolycarbonsäureester zu Flexodruckplatten mit einer guten Flexibilität führen. Dies gilt insbesondere für hoch vernetzte Platten mit einer hohen Härte (Shore A-Härte > 80) und insbesondere bei Verwendung vernetzbarer Bindemittel.

**Tabelle 1: Rezeptur der fotopolymerisierbaren Schicht und Messergebnisse**

| | **Komponente** | **V1** | **V2** | **V3** | **Beispiel 1** |
|---|---|---|---|---|---|
| **Bindemittel** | SIS-Blockcopolymer (Quintac^{®} 3621 C) | 40,9 % | 33,9 % | 33,9 % | 33,9 % |
| | SIS-Blockcopolymer, hoher Vinylanteil (Hybrar® 5125) | 35,0% | 35,0% | 35,0% | 35,0% |
| | Vinyltoluol - Methylstyrol-Copolymer (Piccotex® 100) | 5,0% | 5,0% | 5,0 % | 5,0 % |
| **Monomere** | Hexandioldiacrylat | 11,0% | 11,0 % | 11,0% | 11,0 % |
| | Hexandioldimethacrylat | 4,0% | 4,0% | 4,0% | 4,0% |
| **Initiator** | Benzildimethylketal | 1,8 % | 1,8 % | 1,8% | 1,8 % |
| **Weichmacher** | Cyclohexan-1,2-dicarbonsäuredüsononylsster | - | - | - | 7,0% |
| | Polybutadienöl (Nisso® PB B-1000) | - | 7,0% | - | - |
| | Polybutadienöl (Lithene^{®} N 4 5000) | - | - | 7,0% | - |
| **Additive** | Farbstoffe, Inhibitor für thermische Polymerisation | 2,3% | 2,3% | 2,3% | 2,3% |
| | | | | | |
| **Messwerte** | Flexibilität, Winkel α [°], sofort | 7° | 9° | 10° | 12° |
| | Flexibilität, Winkel α [°], nach 9 Tagen | 11° | 19° | 17° | 27° |
| | Shore A- Härte nach 1 Tag | 88 | 87 | 87 | 87 |
| | Shore A - Härte nach 9 Tagen | 88 | 87 | 87 | 86 |

**Tabelle 1 (Fortsetzung): Ergebnisse der Quellversuche**

| | **Komponente** | | **V1** | **V2** | **V3** | **Beispiel 1** |
|---|---|---|---|---|---|---|
| **Quellversuche Massenzunahme** | Quellung in Hexandioldiacrylat: 1h, 40°C | | 4,5% | 4,9% | 4,6% | 5,0% |
| | Quellung in Hexandioldiacrylat: 24 h, RT | | 12,8% | 13,9% | 13,4% | 13,9% |
| | Quellung in Dipropylenglykoldiacrylat: 1h, 40°C | | 1,7% | 1,8% | 1,6% | 1,5% |
| | Quellung in Dipropylenglykoldiacrylat: 24h, RT | | 3,2% | 3,6% | 3,4% | 2,9% |
| | Handelsübliche gelbe UV-Druckfarbe: 24h, RT | | 1,6% | 2,0% | 1,9% | 1,6% |
| | | | | | | |
| **Quellversuche Härte [Shore A]** | Hexandioldiacrylat: | vor Quellung | 87,5 | 87 | 86,5 | 87 |
| | | 1h, 40°C | 85 | 83 | 83,5 | 82,5 |
| | | 24 h, RT | 78,5 | 77,5 | 77 | 76 |
| | Dipropylenglykoldiacrylat: | vor Quellung | 87 | 87 | 87 | 87 |
| | | 1 h, 40°C | 85,5 | 85 | 85 | 84,5 |
| | | 24 h, RT | 84,5 | 84 | 84 | 83 |
| | Handelsübliche gelbe UV-Druckfarbe: | vor Quellung | 88,5 | 87 | 86,5 | 87 |
| | | 24h, RT | 68 | 64 | 65,5 | 63 |

**Tabelle 2: Rezeptur der fotopolymerisierbaren Schicht und Messergebnisse**

| **Komponente** | **Komponente** | **Beispiel 2** | **Beispiel 3** | **V3** | **V4** | **V5** | **V6** |
|---|---|---|---|---|---|---|---|
| **Bindemittel** | SIS-Blockcopolymer (Quintac^{®} 3621 C) | 35, 4 % | 37,9% | 35,4% | 35,4% | 35,4% | 35,4% |
| | SIS-Blockcopolymer, hoher Vinylanteil (Hybra^{®} 5125) | 36,0% | 38,0% | 36,0 % | 36,0 % | 36,0 % | 36,0 % |
| | Vinyltoluol - Methylstyrol-Copolymer (Piccotex^{®} 100) | 5,0% | 5,0% | 5,0 % | 5,0% | 5,0% | 5,0% |
| **Monomere** | Hexandioldiacrylat | 9,2% | 9,2% | 9,2% | 9,2% | 9,2% | 9,2 % |
| | Hexandioldimethacrylat | 3,3% | 3,3% | 3,3% | 3,3% | 3,3% | 3,3% |
| **Initiator** | Benzildimethylketal | 1,8 % | 1,8 % | 1,8% | 1,8% | 1,8 % | 1,8 % |
| **Weichmacher** | Cyclohexan-1,2-dicarbonsäurediisononylester | 7,0 % | 2,5% | - | - | - | - |
| | Polybutadienöl (Nisso^{®} PB B-1000) | - | - | 7,0 % | - | - | - |
| | Polybutadienöl (Polyöl^{®} 130) | - | - | - | 7,0 % | - | - |
| | Weißöl | - | - | - | - | 7,0 % | - |
| | Diisononyladipat | - | - | - | - | - | 7,0 % |
| **Additive** | Farbstoffe, Inhibitor für thermische Polymerisation | 2,3% | 2,3% | 2,3% | 2,3% | 2,3% | 2,3% |
| | | | | | | | |
| **Messwerte** | Flexibilität, Winkel α [°], sofort | 13° | 8° | 10° | 11° | 10° | 20° |
| | Flexibilität, Winkel α [°], nach 13 Tagen | 25° | 13° | 21° | 19° | 21° | 33° |
| | Shore A- Härte nach 3 Tagen | 85 | 87 | 85 | 84 | 85 | 83 |
| | Shore A - Härte nach 13 Tagen | 85 | 88 | 86 | 85 | 85 | 83 |

**Tabelle 2 (Fortsetzung): Ergebnisse der Quellversuche**

| | **Komponente** | | **Beispiel 2** | **Beispiel 3** | **V3** | **V4** | **V5** | **V6** |
|---|---|---|---|---|---|---|---|---|
| **Quellversuche Massenzunahme** | Quellung in Hexandioldiacrylat: 1h, 40°C | | 5,0% | 4,8% | 4,9% | 4,8% | 4,8% | 5,3% |
| | Quellung in Hexandioldiacrylat: 24 h, RT | | 14,0% | 13,2 % | 13,8% | 13,5% | 13,1 % | 14.3% |
| | Quellung in Dipropylenglykoldiacrylat: 1h, 40°C | | 1,6% | 1,7% | 1,5% | 1,4% | 1,5% | 1,5% |
| | Quellung in Dipropylenglykoldiacrylat: 24h, RT | | 2,9% | 3,0% | 3,2% | 3,2% | 3,1% | 2,3% |
| | Handelsübliche gelbe UV-Druckfarbe: 24h, RT | | 1,6% | 1,5% | 1,9% | 1,7% | 1,9% | 1,4% |
| | | | | | | | | |
| **Quellversuche Härte [Shore A]** | Hexandioldiacrylat: | vor Quellung | 84 | 86,5 | 83 | 84,5 | 84 | 82 |
| | | 1h, 40°C | 79 | 82 | 78,5 | 80 | 78,5 | 77 |
| | | 24 h, RT | 72 | 75 | 72 | 74 | 73 | 69,5 |
| | Dipropylenglykoldiacrylat: | vor Quellung | 84,5 | 86,5 | 82,5 | 84 | 83,5 | 81,5 |
| | | 1h, 40°C | 83 | 85 | 81 | 83,5 | 82 | 80 |
| | | 24 h, RT | 81 | 83,5 | 79 | 82 | 80,5 | 79 |
| | Handelsübliche gelbe UV-Druckfarbe: | vor Quellung | 84 | 85 | 83,5 | 84,5 | 83,5 | 82 |
| | | 24h, RT, Probe gereinigt, 3 Tage Lagerung | 83 | 84 | 82 | 84 | 82,5 | 81,5 |
| | | nochmals 24 h, RT | 81 | 83 | 79 | 81,5 | 80 | 78,5 |

**Tabelle 3: Rezeptur der fotopolymerisierbaren Schicht und Messergebnisse**

| **Komponente** | **Komponente** | **Beispiel 4** | **V7** | **V8** | **V9** |
|---|---|---|---|---|---|
| **Bindemittel** | SIS-Blockcopolymer (Quintac^{®} 3621 C) | 50,9% | 50,9% | 50,9% | 50,9% |
| | SIS-Blockcopolymer (Kraton^{®} D 1113 BT) | 20,0% | 20,0 % | 20,0% | 20,0 % |
| | Vinyltotuol - Methylstrol-Copolymer (Piccotex® 100) | 5,0% | 5,0% | 5,0% | 5,0% |
| **Monomere** | Hexandioldiacrylat | 9,2% | 9,2% | 9,2% | 9,2% |
| | Hexandioldimethacrylat | 3,3% | 3,3% | 3,3% | 3,3% |
| **Initiator** | Benzildimethylketal | 1,3% | 1,3% | 1,3% | 1,3% |
| **Weichmacher** | Cyclohexan-1,2-dicarbonsäurediisononylester | 8,0% | - | - | - |
| | Polybutadienöl (Polyöl^{®} 130) | - | - | 8,0% | - |
| | Polybutadienöl (Lithene^{®} N 4 5000) | - | 8,0% | - | - |
| | Diisononyladipat | - | - | - | 8,0% |
| **Additive** | Farbstoffe, Inhibitor für thermische Polymerisation | 2,3% | 2,3% | 2,3% | 2,3% |
| | | | | | |
| **Messwerte** | Flexibilität, Winkel α [°], sofort | 43° | 45° | 43° | 41° |
| | Flexibilität, Winkel α [°], nach 1 Monat | 44° | 44° | 45° | 44° |
| | Shore A - Härte nach 1 Monat | 75 | 74 | 73 | 75 |

**Tabelle 3 (Fortsetzung): Ergebnisse der Quellversuche**

| | **Komponente** | | **Beispiel 4** | **V7** | **V8** | **V9** |
|---|---|---|---|---|---|---|
| **Quellversuche Massenzunahme** | Quellung in Hexandioldiacrylat: 1h, 40°C | | 9,0% | 9,5% | 9,4% | 9,1 % |
| | Quellung in Hexandioldiacrylat: 24 h, RT | | 20,3% | 22,1 % | 21,7% | 20,6% |
| | Quellung in Dipropylenglykoldiacrylat: 1h, 40°C | | 2,7% | 3,4% | 3,7% | 4,8% |
| | Quellung in Dipropylenglykoldiacrylat: 24h, RT | | 3,2% | 3,6% | 3,4% | 2,9% |
| | Handelsübliche gelbe UV-Druckfarbe: 24h, RT | | 3,2% | 4,3% | 3,8% | 3,0% |
| | | | | | | |
| **Quellversuche Härte [Shore A]** | Hexandioldiacrylat: | vor Quellung | 75 | 74 | 73 | 74,5 |
| | | 1h, 40°C | 68 | 68 | 67 | 68 |
| | | 24 h, RT | 62 | 62 | 61,5 | 62,5 |
| | Dipropylenglykoldiacrylat: | vor Quellung | 75 | 74 | 73 | 74,5 |
| | | 1h, 40°C | 71 | 70 | 70 | 71 |
| | | 24 h, RT | 69,5 | 69 | 68 | 69 |
| | Handelsübliche gelbe UV-Druckfarbe: | vor Quellung | 74 | 71,5 | 72,5 | 74 |
| | | 24h, RT, Probe gereinigt, 3 Tage Lagerung | 73 | 72 | 71,5 | 73 |
| | | nochmals 24 h, RT | 68 | 69,5 | 68,5 | 69,5 |

**Tabelle 4: Rezeptur der fotopolymerisierbaren Schicht und Messergebnisse**

| | **Komponente** | **Beispiel 5** | **V10** | **V11** |
|---|---|---|---|---|
| **Bindemittel** | SIS-Blockcopolymer (Quintac^{®} 3621) | 68,5% | 68,5% | 68,5% |
| | Vinyltoluol - Methylstrol-Copolymer (Piccotex® 100) | 5,0% | 5,0% | 5,0% |
| **Monomere** | Hexandioldiacrylat | 13,8% | 13,8% | 13,8% |
| | Hexandioldimethacrylat | 5,0% | 5,0% | 5,0 % |
| **Initiator** | Benzildimethylketal | 1,5% | 1,5% | 1,5% |
| **Weichmacher** | Cyclohexan-1,2-dicarbonsäurediisononylester | 5,0% | - | - |
| | Polybutadienöl (Nisso^{®}PB B-1000) | - | 5,0% | - |
| | Polybutadienöl (Lithene^{®} N 4 5000) | - | - | 5,0% |
| **Additive** | Farbstoffe, Inhibitor für thermische Polymerisation | 1,2 % | 1,2 % | 1,2% |
| | | | | |
| **Messwerte** | Flexibilität, Winkel α [°], sofort | 41° | 39° | 41° |
| | Flexibilität, Winkel α [°], nach 12 Tagen | 48° | 44° | 48° |
| | Shore A - Härte nach 12 Tagen | 77 | 76 | 77 |

**Tabelle 4 (Fortsetzung): Ergebnisse der Quellversuche**

| | **Komponente** | | **Beispiel 5** | **V10** | **V11** |
|---|---|---|---|---|---|
| **Quellversuche Massenzunahme** | Quellung in Hexandioldiacrylat: 1 h, 40°C | | 5,6% | 5,7% | 6,0% |
| | Quellung in Hexandioldiacrylat: 24 h, RT | | 14,6% | 14,9% | 16,4% |
| | Quellung in Dipropylenglykoldiacrylat: 1h, 40°C | | 1,4% | 4,6% | 2,3% |
| | Quellung in Dipropylenglykoldiacrylat: 24h, RT | | 2,6 % | 2,9% | 4,7% |
| | Handelsübliche gelbe UV-Druckfarbe: 24h, RT | | 3,1 % | 3,2% | 3,0% |
| | | | | | |
| **Quellversuche Härte [Shore A]** | Hexandioldiacrylat: | vor Quellung | 76,5 | 76,5 | 78,5 |
| | | 1h, 40°C | 71 | 71,5 | 73,5 |
| | | 24 h, RT | 66,5 | 66,5 | 67 |
| | Dipropylenglykoldiacrylat: | vor Quellung | 77 | 77 | 78,5 |
| | | 1 h, 40°C | 73,5 | 74 | 76,5 |
| | | 24 h, RT | 73,5 | 74 | 75,5 |
| | Handelsübliche gelbe UV-Druckfarbe: | vor Quellung | 76,5 | 76,5 | 78,5 |
| | | 24h, RT | 56,5 | 57,5 | 57,5 |

**Tabelle 5: Rezeptur der fotopolymerisierbaren Schicht und Messergebnisse**

| | **Komponente** | **Beispiel 6** | **V12** | **V13** |
|---|---|---|---|---|
| **Bindemittel** | SIS-Blockcopolymer (Quintac^{®} 3621) | 76,2% | 71,9 % | 71,9% |
| | Vinyltotuol - Methylstrol-Copolymer (Piccotex^{®} 100) | 5,0% | 5,0% | 5,0% |
| **Monomere** | Hexandioldiacrylat | 9,2% | 9,2% | 9,2% |
| | Hexandioldimethacrylat | 3,3% | 3,3% | 3,3% |
| **Initiator** | Benzildimethylketal | 2,3% | 2,3% | 2,3% |
| **Weichmacher** | Cyclohexan-1,2-dicarbonsäurediisononylester | 1,7% | - | - |
| | Polybutadienöl (Nisso^{®} PB B-1000) | - | 6,0% | |
| | Polybutadienöl (Polyöl^{®} 130) | - | - | 6,0% |
| **Additive** | Farbstoffe, Inhibitor für thermische Polymerisation | 2,3% | 2,3% | 2,3% |
| | | | | |
| **Messwerte** | Flexibilität, Winkel α [°], nach 20 Monaten | 32° | 35° | 32° |
| | Shore A - Härte nach 20 Monaten | 81 | 78 | 77 |

## Patentansprüche

1. Fotopolymerisierbares Flexodruckelement zur Herstellung von Flexodruckformen für den Druck mit UV-Farben umfassend mindestens
- einen dimensionsstabilen Träger sowie
- eine fotopolymerisierbare, reliefbildende Schicht umfassend mindestens
■ 40 bis 90 Gew.-% eines thermoplastisch-elastomeren Blockcopolymers, umfassend mindestens einen Block, welcher im Wesentlichen aus Alkenylaromaten besteht und mindestens einen Block, welcher im Wesentlichen aus 1,3-Dienen besteht,
■ 1 bis 20 Gew.-% ethylenisch ungesättigte Monomere,
■ 0,1 bis 5 Gew.-% Fotoinitiator und
■ 1 bis 40 Gew.-% Weichmacher,
wobei die Mengen jeweils auf die Gesamtmenge aller Komponenten der fotopolymerisierbaren Schicht bezogen sind,
**dadurch gekennzeichnet, dass** es sich bei mindestens einem der Weichmacher um 1 bis 40 Gew.-% mindestens eines Cyclohexanpolycarbonsäureesters der allgemeinen Formel R¹-(COOR²)ₙ handelt, wobei n für 2, 3 oder 4 steht, R¹ für einen n-wertigen Cyclohexanrest und die Reste R² jeweils unabhängig voneinander für einen linearen, verzweigten oder cyclischen, aliphatischen Kohlenwasserstoffrest mit 3 bis 20 Kohlenstoffatomen.

2. Fotopolymerisierbares Flexodruckelement gemäß Anspruch 1, **dadurch gekennzeichnet, dass** es sich bei dem Weichmacher um einen Cyclohexan-1,2-dicarbonsäureester R¹-(COOR²)₂ handelt.

3. Fotopolymerierbares Flexodruckelement gemäß Anspruch 1 oder 2, **dadurch gekennzeichnet, dass** es sich bei R² um einen linearen, verzweigten oder cyclischen, aliphatischen Kohlenwasserstoffrest mit 6 bis 12 Kohlenstoffatomen handelt.

4. Fotopolymerisierbares Flexodruckelement gemäß Anspruch 1, **dadurch gekennzeichnet, dass** es sich bei dem Weichmacher um Cyclohexan-1,2-dicarbonsäurediisononylester handelt.

5. Fotopolymerisierbares Flexodruckelement gemäß einem der Ansprüche 1 bis 4, **dadurch gekennzeichnet, dass** bei den thermoplatisch-elastomeren Bindemitteln um mindestens ein Styrol-Isopren-Blockcopolymer mit einem Styrolgehalt von 10 bis 30 Gew. % handelt.

6. Fotopolymerisierbares Flexodruckelement gemäß Anspruch 5, **dadurch gekennzeichnet, dass** es sich bei dem Bindemittel um ein radiales Styrol-Isopren-Blockcopolymer handelt.

7. Fotopolymerisierbares Flexodruckelement gemäß einem der Ansprüche 1 bis 4, **dadurch gekennzeichnet, dass** bei den thermoplatisch-elastomeren Bindemitteln um mindestens zwei verschiedene Styrol-Isopren-Blockcopolymere mit einem Styrolgehalt von jeweils 10 bis 25 Gew. % handelt, wobei eines der beiden Blockcopolymere einen Polyisoprenblock mit einem 1,2-Vinylgruppengehalt von mindestens 20 % aufweist.

8. Fotopolymerisierbares Flexodruckelement gemäß einem der Ansprüche 1 bis 7, **dadurch gekennzeichnet, dass** die Menge an ethylenisch ungesättigten Monomeren 5 bis 20 Gew.-% beträgt.

9. Fotopolymerisierbares Flexodruckelement gemäß einem der Ansprüche 1 bis 8, **dadurch gekennzeichnet, dass** mindestens ein Monomer mit zwei ethylenisch ungesättigten Gruppen eingesetzt wird.

10. Verfahren zum Herstellen von Flexodruckformen für den Druck mit UV-Farben durch bildmäßiges Belichten der fotopolymerisierbaren reliefbildenden Schicht mit aktinischem Licht und Entwickeln der belichteten, reliefbildenden Schicht oder vollflächiges Belichten der fotopolymerisierbaren, reliefbildenden Schicht und Eingravieren des Druckreliefs in die belichtete, Reliefschicht unter Verwendung eines Lasers, **dadurch gekennzeichnet, dass** man ein fotopolymerisierbares Flexodruckelement gemäß einem der Ansprüche 1 bis 9 einsetzt.

11. Verwendung von Flexodruckformen erhältlich durch das Verfahren gemäß Anspruch 10, zum Flexodruck mit UV-Farben.

12. Verwendung nach Anspruch 11, **dadurch gekennzeichnet, dass** man mindestens eine Flexodruckform auf einen Druckzylinder montiert, mittels eines Farbwerkes UV-härtbare Druckfarbe auf die Flexodruckform überträgt, die UV-härtbare Druckfarbe durch Rotieren des Druckzylinders von der Flexodruckform auf den Bedruckstoff überträgt und danach die UV-härtbare Druckfarbe auf dem Substrat mittels UV-Strahlung aushärtet.

13. Verwendung gemäß Anspruch 12, **dadurch gekennzeichnet, dass** es sich um Schmalbahnetikettendruck handelt, wobei der Druckzylinder eine Länge von nicht mehr als 60 cm und einen Durchmesser von 5 bis 15 cm aufweist.

14. Verwendung gemäß Anspruch 12 oder 13, **dadurch gekennzeichnet, dass** die eingesetzte Druckfarbe als Monomere mindestens einen Acrylester von Polyetherpolyolen enthalten.

15. Verwendung gemäß Anspruch 12 oder 13, **dadurch gekennzeichnet, dass** die eingesetzte Druckfarbe als Monomere mindestens ein Monomer ausgewählt aus der Gruppe von ethoxyliertem Tripropylenglykoldiacrylat, ethoxyliertem Trimethylolpropantriacrylat, Dipropylenglykoldiacrylat oder Tripropylenglykoldiacrylat enthalten.

## Claims

1. Photopolymerisable flexographic printing element for the production of flexographic printing forms for printing with UV inks, comprising at least
- a dimensionally stable support and
- a photopolymerisable, relief-forming layer comprising at least
• from 40 to 90 wt.% of a thermoplastic-elastomeric block copolymer comprising at least one block which consists substantially of alkenylaromatics and at least one block which consists substantially of 1,3-dienes,
• from 1 to 20 wt.% ethylenically unsaturated monomers,
• from 0.1 to 5 wt.% photoinitiator, and
• from 1 to 40 wt.% plasticiser,
wherein the amounts are based in each case on the total amount of all the components of the photopolymerisable layer,
**characterised in that** at least one of the plasticisers is from 1 to 40 wt.% of at least one cyclohexanepoly-carboxylic acid ester of the general formula R¹-(COOR²)ₙ, wherein n represents 2, 3 or 4, R¹ represents an n-valent cyclohexane radical and the radicals R² each independently of the other(s) represents a linear, branched or cyclic, aliphatic hydrocarbon radical having from 3 to 20 carbon atoms.

2. Photopolymerisable flexographic printing element according to claim 1, **characterised in that** the plasticiser is a cyclohexane-1,2-dicarboxylic acid ester R¹-(COOR²)₂.

3. Photopolymerisable flexographic printing element according to claim 1 or 2, **characterised in that** R² is a linear, branched or cyclic, aliphatic hydrocarbon radical having from 6 to 12 carbon atoms.

4. Photopolymerisable flexographic printing element according to claim 1, **characterised in that** the plasticiser is cyclohexane-1,2-dicarboxylic acid diisononyl ester.

5. Photopolymerisable flexographic printing element according to any one of claims 1 to 4, **characterised in that** the thermoplastic-elastomeric binders are at least one styrene-isoprene block copolymer having a styrene content of from 10 to 30 wt.%.

6. Photopolymerisable flexographic printing element according to claim 5, **characterised in that** the binder is a radial styrene-isoprene block copolymer.

7. Photopolymerisable flexographic printing element according to any one of claims 1 to 4, **characterised in that** the thermoplastic-elastomeric binders are at least two different styrene-isoprene block copolymers each having a styrene content of from 10 to 25 wt.%, wherein one of the two block copolymers contains a polyisoprene block having a 1,2-vinyl group content of at least 20%.

8. Photopolymerisable flexographic printing element according to any one of claims 1 to 7, **characterised in that** the amount of ethylenically unsaturated monomers is from 5 to 20 wt.%.

9. Photopolymerisable flexographic printing element according to any one of claims 1 to 8, **characterised in that** at least one monomer having two ethylenically unsaturated groups is used.

10. Process for the production of flexographic printing forms for printing with UV inks by the image-wise exposure of the photopolymerisable relief-forming layer to actinic light and development of the exposed, relief-forming layer, or by exposure of the entire photopolymerisable, relief-forming layer and engraving of the printing relief into the exposed relief layer using a laser, **characterised in that** a photopolymerisable flexographic printing element according to any one of claims 1 to 9 is used.

11. Use of flexographic printing forms obtainable by the process according to claim 10 for flexographic printing with UV inks.

12. Use according to claim 11, **characterised in that** at least one flexographic printing form is mounted on a printing cylinder, UV-curable printing ink is transferred to the flexographic printing form by means of an inking system, the UV-curable printing ink is transferred from the flexographic printing form to the material for printing by rotation of the printing cylinder, and then the UV-curable printing ink is cured on the substrate by means of UV radiation.

13. Use according to claim 12, **characterised in that** it is narrow web printing, the printing cylinder having a length of not more than 60 cm and a diameter of from 5 to 15 cm.

14. Use according to claim 12 or 13, **characterised in that** the printing ink used contains as monomers at least one acrylic ester of polyether polyols.

15. Use according to claim 12 or 13, **characterised in that** the printing ink used contains as monomers at least one monomer selected from the group ethoxylated tripropylene glycol diacrylate, ethoxylated trimethylolpropane triacrylate, dipropylene glycol diacrylate and tripropylene glycol diacrylate.

## Revendications

1. Élément d'impression flexographique photopolymérisable pour la fabrication de clichés flexographiques pour l'impression avec des encres UV comprenant au moins
- un support résistant à la déformation, et
- une couche photopolymérisable formant un relief, comprenant au moins
■ à concurrence de 40 à 90 % en poids, un copolymère séquencé élastomère thermoplastique comprenant au moins une séquence qui est constituée essentiellement par des composés alcénylaromatiques et au moins une séquence qui est constituée essentiellement par des 1,3-diènes,
■ à concurrence de 1 à 20 % en poids, des monomères à insaturation éthylénique,
■ à concurrence de 0,1 à 5 % en poids, un ou plusieurs photoinitiateurs, et
■ à concurrence de 1 à 40 % en poids, un ou plusieurs plastifiants ;
les quantités se rapportant respectivement à la quantité totale de tous les composants de la couche photopolymérisable,
**caractérisé en ce que**, en ce qui concerne au moins un des plastifiants, il s'agit, à concurrence de 1 à 40 % en poids, d'au moins un ester d'acide cyclohexanepolycarboxylique répondant à la formule générale R¹(COOR²)ₙ dans laquelle n est égal à 2, 3 ou 4, R¹ représente un radical cyclohexane de valence n, et les radicaux R² représentent de manière respectivement indépendante un radical d'hydrocarbure aliphatique linéaire, ramifié ou cyclique, contenant de 3 à 20 atomes de carbone.

2. Élément flexographique photopolymérisable selon la revendication 1, **caractérisé en ce que**, en ce qui concerne le plastifiant, il s'agit d'un ester d'acide cyclohexane-1,2-dicarboxylique R¹-COOR²)₂.

3. Élément flexographique photopolymérisable selon la revendication 1 ou 2, **caractérisé en ce que**, en ce qui concerne R², il s'agit d'un radical d'hydrocarbure aliphatique linéaire, ramifié ou cyclique, contenant de 6 à 12 atomes de carbone.

4. Élément flexographique photopolymérisable selon la revendication 1, **caractérisé en ce que**, en ce qui concerne le plastifiant, il s'agit de l'ester diisononylique de l'acide cyclohexane-1,2-dicarboxylique.

5. Élément flexographique photopolymérisable selon l'une quelconque des revendications 1 à 4, **caractérisé en ce que**, en ce qui concerne les liants élastomères thermoplastiques, il s'agit d'au moins un copolymère séquencé de styrène-isoprène possédant une teneur en styrène de 10 à 30 % en poids.

6. Élément flexographique photopolymérisable selon la revendication 5, **caractérisé en ce que**, en ce qui concerne le liant, il s'agit d'un copolymère séquencé radial de styrène-isoprène.

7. Élément flexographique photopolymérisable selon l'une quelconque des revendications 1 à 4, **caractérisé en ce que**, en ce qui concerne les liants élastomères thermoplastiques, il s'agit d'au moins deux copolymères séquencés différents de styrène-isoprène possédant une teneur en styrène de respectivement 10 à 25 % en poids, un des deux copolymères séquencés présentant une séquence de polyisoprène dont la teneur en groupes 1,2-vinyle s'élève à au moins 20 %.

8. Élément flexographique photopolymérisable selon l'une quelconque des revendications 1 à 7, **caractérisé en ce que** la quantité des monomères à insaturation éthylénique s'élève de 5 à 20 % en poids.

9. Élément flexographique photopolymérisable selon l'une quelconque des revendications 1 à 8, **caractérisé en ce qu'**on met en oeuvre au moins un monomère comprenant deux groupes à insaturation éthylénique.

10. Procédé pour la fabrication de clichés flexographiques pour l'impression avec des encres UV par exposition en forme d'image à de la lumière actinique de la couche photopolymérisable formant un relief et développement de la couche exposée formant un relief ou par exposition sur toute la surface de la couche photopolymérisable formant un relief et gravure du relief d'impression dans la couche en relief exposée en utilisant un laser, **caractérisé en ce qu'**on met en oeuvre un élément d'impression flexographique photopolymérisable selon l'une quelconque des revendications 1 à 9.

11. Utilisation de clichés d'impression flexographiques que l'on obtient via le procédé selon la revendication 10, pour l'impression flexographique avec des encres UV.

12. Utilisation selon la revendication 11, **caractérisée en ce qu'**on monte au moins un cliché d'impression flexographique sur un cylindre d'impression, on transfère sur le cliché d'impression flexographique, au moyen d'un système d'encrage, des encres d'impression durcissables par exposition au rayonnement ultraviolet, on transfère du cliché d'impression flexographique au substrat d'impression, les encres d'impression durcissables par exposition au rayonnement ultraviolet par rotation du cylindre d'impression, et on durcit ensuite sur le substrat au moyen d'un rayonnement ultraviolet les encres d'impression durcissables par exposition au rayonnement ultraviolet.

13. Utilisation selon la revendication 12, **caractérisée en ce qu'**il s'agit d'une impression d'étiquettes en bande étroite, le cylindre d'impression présentant une longueur qui n'est pas supérieure à 60 cm et un diamètre de 5 à 15 cm.

14. Utilisation selon la revendication 12 ou 13, **caractérisée en ce que** les encres d'impression mises en oeuvre contiennent à titre de monomères, au moins un ester acrylique de polyétherpolyols.

15. Utilisation selon la revendication 12 ou 13, **caractérisée en ce que** les encres d'impression mises en oeuvre contiennent à titre de monomères, au moins un monomère choisi parmi le groupe du diacrylate de tripropylèneglycol éthoxylé, du triacrylate de triméthylolpropane éthoxylé, du diacrylate de dipropylèneglycol ou du diacrylate de tripropylèneglycol.
